# EUROPEAN PATENT SPECIFICATION

(11) **EP 1 546 739 B1**
(45) Date of publication and mention of the grant of the patent: **13.12.2006**
(21) Application number: 03798278.2
(22) Date of filing: 12.09.2003
(51) Int. Cl.: G01R 1/04, G01R 31/28, H04B 17/00

(54) **RF CHIP TESTING METHOD AND SYSTEM**
VERFAHREN UND SYSTEM ZUR PRÜFUNG VON RF CHIPS
PROCEDE ET SYSTEME D'ESSAI DE PUCES RF

(30) Priority: 28.09.2002 GB 0222556
(43) Date of publication of application: 29.06.2005
(73) Proprietor: Koninklijke Philips Electronics N.V., 5621 BA Eindhoven (NL)
(72) Inventor: Guthrie, Brian J. Philips I.P. & Standards, Redhill, Surrey RH1 5HA (GB); Spencer, Adrian G. Philips I.P. & Standards, Redhill, Surrey RH1 5HA (GB)
(74) Representative: White, Andrew Gordon
(86) International application number: PCT/IB2003/003987
(87) International publication number: WO 2004/029636

(56) References cited:
- DE-A- 3 229 749
- US-A- 5 337 316
- US-A- 5 481 186
- US-B1- 6 396 291
- PATENT ABSTRACTS OF JAPAN vol. 2002, no. 11, & JP 2002 214292 A (ADVANTEST CORP), 31 July 2002 (2002-07-31)

## Description

The present invention relates to radio frequency (RF) testing methods and further relates to a testing system suitable for practising such methods. The present invention has particular, but not exclusive, application in the testing of the RF functionality of integrated circuit chips and the compliance of such functionality with an intended radio standard or specification.

Radio frequency integrated circuit (IC or 'chip') manufacturing requires testing to determine whether the manufactured ICs are compliant with a radio standard (e.g. Bluetooth^{™}, GSM^{™}, IEEE802.15.4) and operational in other respects. Typically, a pick and place machine will place the chip device to be tested in a suitably constructed test board or 'test head' of specialised automated test equipment (ATE). The ATE applies the appropriate test signals to the device under test (DUT) and passes or rejects the device. Such individual chip testing exhibits a problem in that it is time consuming and hence adds to the overall manufacturing cost.

Another particular problem in testing the functionality of an RF chip for compliance with a radio standard exists in that the specification may require the ATE to generate several specific analogue RF signals at the same time in order to test, for example, the interference performance of the receiver of the DUT. Special signal generating hardware is therefore required, adding cost to the ATE, and therefore expense to the manufacturer. Furthermore, the application of such signals is often via long probes brought down into contact with the pin-out of the chips, requiring a specially constructed and controlled test suite. The use of such probes results in unspecified and difficult to quantify losses reducing the accuracy of any such test.

United States Patent 5,337,316 discloses a transceiver self-diagnostic testing apparatus and method which includes an apparatus and a method for transceiver self-diagnostic testing in a communication system. A feedback unit is utilized that allows performance of a loopback test independent of a transmit frequency to receive frequency difference without undue proliferation of circuitry.

United States Patent 5,481,186 discloses a method and apparatus for integrated testing of a system containing digital and radio frequency circuits. The method is provided for accomplishing unified testing of a digital/RE system, comprised of a digital controller, a base-band processor, an RF transmitter and an RE receiver. The digital portion of the digital/RF system, including the digital controller and the base-band processor, is tested by a digital test technique such as Boundary-Scan testing. Test patterns for the RF elements are down-loaded from the digital controller to the base-band processor via a Boundary-Scan Test Access Port (TAP). Thereafter, the RE transmitter and the RE receiver are tested by applying the test patterns from the base-band processor to the RE transmitter for transmission thereby. The signal produced by the RE transmitter in response to the applied test pattern is converted to a first digital signal stream for processing by the base-band processor to determine the operability of the transmitter. The signal produced by the RE transmitter is also received by the RE receiver for demodulation thereby. The demodulated receiver signal is then converted to a second signal stream for input to the base-band processor to determine the operability of the receiver.

United States Patent 6,396,291 discloses a system and method for testing semiconductor components. The system includes: a test board, sockets mounted to the test board in electrical communication with test circuitry, and carriers mounted to the sockets for housing the components. The carriers include bases, and interconnects mounted thereon, having contact members configured to make temporary electrical connections with contacts on the components. During a test procedure, the bases and interconnects can remain mounted to the sockets on the test board, as the components are aligned and placed in electrical contact with the interconnects.

It is therefore an object of the present invention to provide an improved method and system for RF chip testing.

According to a first aspect of the present invention there is provided a method for testing a plurality of integrated circuit chips for compliance with a radio standard, each chip having transmission means and receiving means for sending and receiving RF signals, the method comprising:
- placing the chips in close proximity to one another,
- testing the transmission means of each chip with respect to a known good reference chip,
- selecting a number of the chips to form a generating group, the remaining chips forming a receiving group, and
- testing the receiving group using signals generated by the generating group.

According to a further aspect of the present invention there is provided a testing system for testing a plurality of integrated circuit chips, each chip having transmission means and receiving means for sending and receiving RF signals, the system comprising:
a test board comprising a plurality of chip sockets adapted to physically accept and electronically interface with a chip placed therein, and wherein each socket is provided with signal propagation and attenuation means for sending and receiving test signals generated by at least one chip to each of the other sockets.

The method and system of the present invention implement applicant's appreciation that many compliance tests in the RF field require a number of signals to be generated, and that the RF chips being tested may be utilised in the system to generate such signals. Hence, a system is provided in which a group of chips, having passed transmission generation tests for example, are utilised to generate the signals required to test the reception hardware of the other chips.

Preferably, the number of chips selected corresponds to the number of signals required for the particular test. For example, in an interference test a "wanted" signal with two other "interfering signals" must be generated on certain specified channels to determine the quality of the receiver. In such an example test, three chips are therefore required to be selected for the test. If one considers the situation where there are eight chips mounted in the system, then such an interference test requires that three chips are selected (the generating group) to provide the three signals to the remaining five chips (the receiving test group). Following the test, three of the five chips just tested may be selected for the generation group and these then provide the signals to the previous generating group. Hence, such an interference test only requires two "passes" to test all eight chips, and no extra signal generating hardware. This compared with eight individual tests required in a conventional system which in addition requires signal generating hardware to generate the three signals for the above example test, and individual probing (which has the disadvantage of including unknown losses due to such probing).

Advantageously, each chip's signal may be attenuated via programmable attenuators before being provided to the test group of chips. This allows for imbalance in transmission and reception power required for a test. For example the Bluetooth specification requires a transmission power of OdBm whilst the chips receiving hardware requires a signal of the order of -70dBm, therefore the signals generated by the group of chips require 70dB attenuation.

In a preferred embodiment, the computer is a standard PC with a digital data acquisition card to interface it to the test board. The control and test routines and analysis of data captured by the card are provided in software. Hence this digital test equipment is relatively inexpensive and flexible enabling different tests for different radio specifications to be installed or downloaded as required by the customer.

The present invention will now be described, by way of example only, and with reference to the accompanying drawings wherein:
Figure 1 is a block diagram of the circuitry of an RF chip being a device under test (DUT);
Figure 2 is a schematic diagram of a system for testing a chip as shown in Fig. 1;
Figure 3 is flow diagram representing example steps of a method embodying the invention;
Figure 4 is another flow diagram representing example steps of a method embodying the invention in which intermodulation and other receiver tests are performed.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

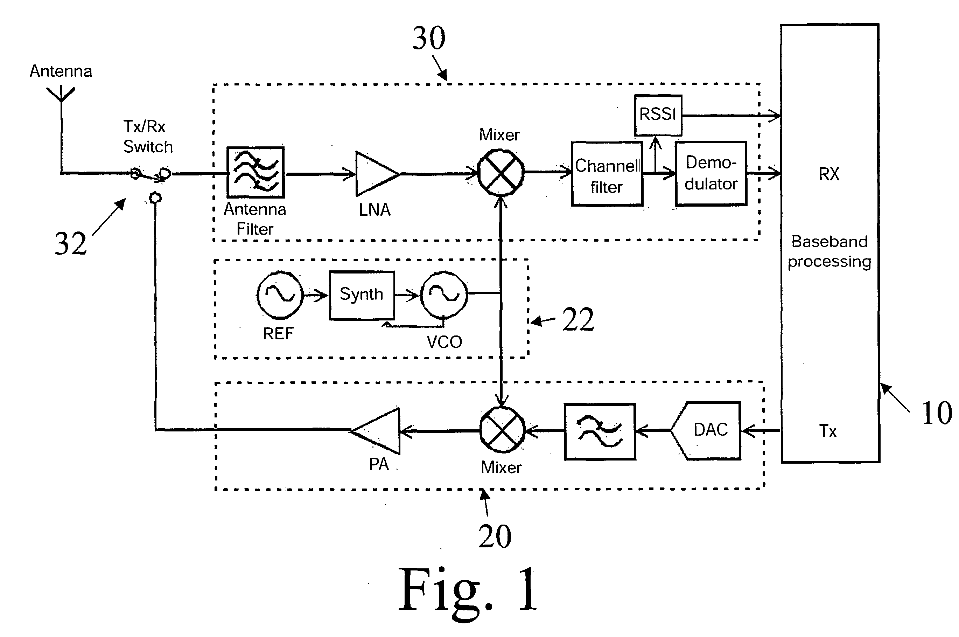

Figure 1 shows a typical transceiver architecture for an RF chip. This architecture comprises a baseband section 10 connected with a transmission chain 20 comprising a digital to analog converter (DAC) for converting the intended digital signal to an analogue signal, a mixing stage where the signal is mixed with the output of a frequency synthesiser block 22 and a power amplifier for amplifying the resulting signal. A receiving chain 30 comprises an antenna filter, a low noise amplifier, a mixing stage, channel filtering and demodulating stage. Such a general transceiver having transmission and reception means for generating and transmitting/receiving signals is well known to those skilled in the art. In an application, for example a mobile phone or personal digital assistant (PDA), the transceiver is connected to an antenna for radiating or receiving radiated signals. In a testing environment, prior to incorporation in a final product such as a mobile phone, the transceiver (Tx) 20 and receiver (Rx) 30 blocks are connected to relevant pins of the chip (if packaged) or a pad/probe applied to the appropriate test location on the silicon die containing the transceiver circuitry (if testing is prior to packaging).

An integrated circuit for producing for example, Bluetooth signals may do so via such an architecture as shown in Fig. 1, together with a layered protocol. The Bluetooth protocol or specification as laid out in the Bluetooth specification v1.1 requires the radio performance of such a chip to meet certain test requirements. Pages 20-32 of the aforementioned specification, which are incorporated herein for reference and to which the reader is now directed, specify among others the following tests: output power and power control of the transmitter, sensitivity, interference performance, intermodulation characteristic and receiver signal strength indicator.

It is to be noted that several of these tests require a number of signals to be generated at the same time. In particular, characterisation of the receiver for interference performance involves co-channel and adjacent channel tests which each require two transmission signals to be generated. The characterisation and testing of the intermodulation characteristics of the receiver require three signals to be generated - a wanted signal at a first frequency f₀ with a power level 6dB over the reference sensitivity level, a static sine wave signal at another frequency f₁ with a power level of -39 dBm and a bluetooth modulated signal at a further frequency f₂ with a power level of - 39dBm, such that f₀ - 2f₁ -f₂ and mod(f₂-f₁) = n*1 MHz where n can be 3, 4, or 5. In general the Bit Error Rate (BER) is measured and evaluated against a predetermined level (e.g. 0.1 %) to provide a pass/fail for these tests.

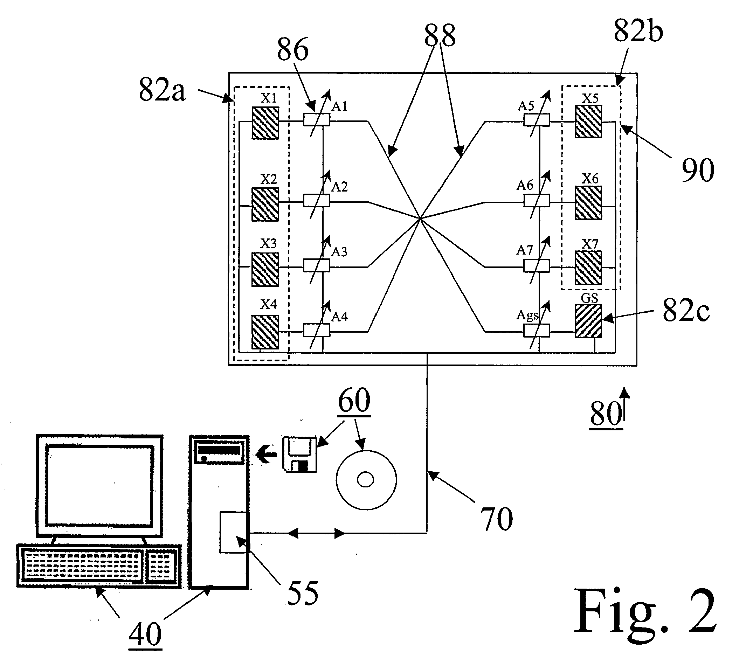

Figure 2 is a diagram of a digital testing system embodying the present invention. The system comprises a computer in the form of a PC 40 having a display and a digital acquisition card (DAQ) 55, a suitable example being National Instruments^{™} PCI 7030/6030E. Testing routines, control and analysis software are provided with the computer on suitable media 60, or may be downloaded over a suitable internet link (not shown). The computer and DAQ are connected to a test board or "test head" 80 via a SCSI link 70 although other suitable interface links 70 may be used (IEEE1394 'Firewire', and USB being common examples).

The board 80 comprises in this embodiment eight chip sockets 82a,b,c (labelled X1,X2 to X7, and GS in the diagram) for accepting radio chips for testing. Each socket interfaces electronically (via techniques well known in the art such as tensioned pins or solderbump pads) with the chip mounted therein. Suitably designed tracks 88 with programmable attenuators 86 (A1 to A7, Ags) for interconnecting and propagating signals from one chip socket to another are provided. Control and input/output (I/O) data is passed between the computer 40 and sockets via the test head link 70. In this embodiment the socket 82c is provided for a "golden sample" chip. This chip has been previously tested and characterised and is used as a reference with which to compare the characteristics of other chips just manufactured.

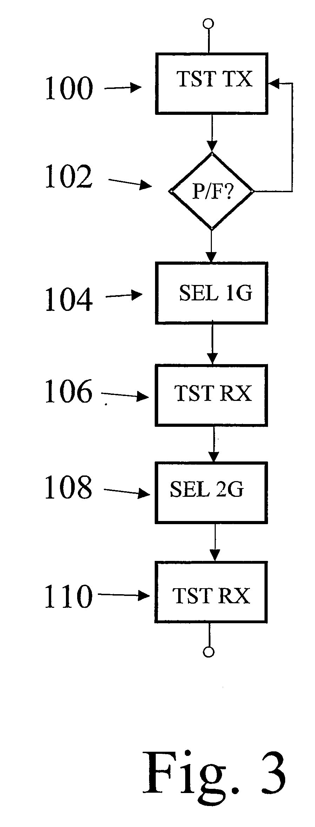

Figure 3 illustrates a flow chart example of a testing method performed by the system of Figure 2, and as implemented by software 60. In the method chips are loaded into sockets 82a,b. The golden sample socket 82c is loaded with a golden sample. In the basic method according to the invention the transmission circuitry 20 of each chip is tested (step 100) with respect to the golden sample. For example the power output of each transceiver may be measured and compared with the known golden sample power output which is within the specified Bluetooth requirements. After testing all of the loaded chips X1-X7, the computer determines (step 102) whether the result was a pass or fail for each chip and stores the result in memory. The testing then moves onto testing the receiver chain 30 of each chip for specification compliance.

In step 104 the computer selects a first group of chips (for example the chips mounted in sockets X5, X6 and X7 as denoted by the dashed box labelled 82b in Figure 2) which will form a signal generating group for generating the signals which must be received by the remaining test chips 82a in order to test the receiver circuitry 30 of those remaining chips. Under the control of the computer the receiving group of chips are each subjected to the signals generated by the first group, thereby testing the receiver circuitry 30 of those chips in parallel (step 106). In this embodiment, the transmitted signals from X5, X6 and X7 are attenuated by the programmable attenuators A5, A6, A7 and then passed down signal propagation tracks 88 to the receiver test group 82a of X1, X2, X3 and X4. Following step 106, the generating group becomes a receiving group to enable testing of the receiver circuitry of those chips, and a new second generating group is selected ('SEL 2G' step 108) to generate the test signals. The receiving group (which acted as the first generating group previously) is subsequently tested in step 110 and the results from the tests analysed.

Hence, RF analogue signals which are required for testing the receiver functionality of a radio chip are generated "on-board" by a group of chips which themselves form part of the test. Additionally, the signals are routed to the test chips in parallel, hence saving time and effectively testing the receiver group of chips instantaneously.

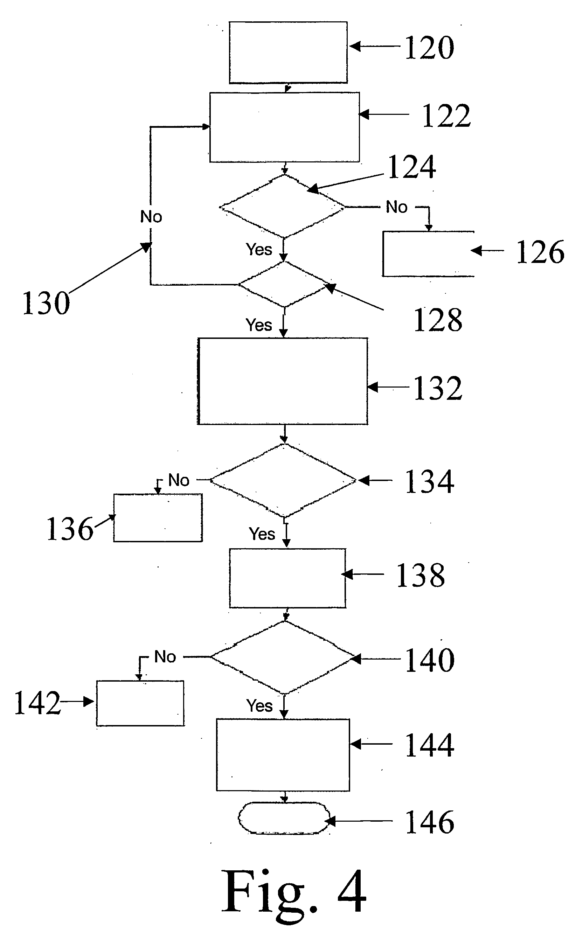

Figure 4 illustrates a flowchart giving a particular example of testing requirements which are necessary for evaluating a Bluetooth^{™} radio chip and wherein a methodology embodying the invention is applied. In this particular example seven chips labelled X1 to X7 are to be tested with respect to a golden sample for transmission characteristics (power output and control) and receiver characteristics (intermodulation, co-channel, adjacent channel, sensitivity and Receiver Signal Strength Indicator (RSSI)), wherein:
- block 120 - IC's Xᵢ (i=1 to 7) are loaded as is the golden sample chip, following which;
- block 122 - IC Xᵢ transmits a signal sᵢ at a first frequency f1 to the golden sample chip, and attenuator Aᵢ is programmed to reduce the power of signal sᵢ, after which;
- in block 124 the BER of the signal sᵢ as received by the golden sample is analysed and a decision is made as to whether the transmitter of Xᵢ is either:
   o not within specification (block 126), Xᵢ is characterised as a reject and is not included in any further tests,
   o or is within specification, the result is stored and
- in block 128, a determination is made (is i<7?) whether all chips have been tested. If there are still chips to be tested then i=i+1 and the program flow follows path 130 back to block 122. Once all chips have been tested (i=7) then the program flow moves to the next required tests in block 132;
- Block 132 - Intermodulation tests are performed to determine receiver characteristics. X1, X3 and X3 selected to provide a wanted signal, an interfering signal and a co-channel signal respectively. A1, A2 and A3 are programmed to limit outputs;
- Block 134 - the signals are provided by X1, X2 and X3 to the remaining chips X4, X5, X6 and X7 and the results analysed for each IC as to whether it:
   o Fails - block 136 - IC is rejected as receiver not within specification
   o Or passes in which case flow moves to
- Block 138 wherein X4, X5 and X6 are selected to generate the intermodulation test signals and A4, A5 and A6 programmable attenuators are programmed to limit outputs, following which:
- Block 140, the signals are provided by X4, X5 and X6 to the remaining chips X1, X2, X3 and the results analysed for each IC as to whether it:
   o Fails - block 142 - IC is rejected as receiver not within specification
   o Or passes in which case flow moves to
- Block 144 wherein the remaining RF tests (co-channel, Adjacent channel, sensitivity and RSSI calibration are performed on those chips which have previously passed the transmitter tests (block 124) and the intermodulation receiver tests (blocks 134 and 140) after which
- those IC which have passed all tests are noted as being within test specification requirements.

In the above embodiments an example testing system and methods were described with reference to packaged Bluetooth^{™} radio chips.

In an alternative embodiment the sockets for accepting chips are replaced with suitably designed solder pads on which singulated die may be placed. Testing may then be executed as described previously. Hence, in this embodiment a manufacturer is able to test integrated circuit chips in the form of singulated die before packaging, thereby enabling faster quality testing "upstream" of the packaging process.

Those skilled in the art of testing will recognise that implementing the example testing flow charts of Fig. 3 and Fig. 4 is a matter of software design for the digital testing equipment designer. The overall software control, interfacing and analysis aspects of the testing system may be routinely implemented by those skilled in the art of designing and building test heads and testing systems. Other well known features of automatic testing equipment, such as a "pick and place" machine for handling and loading/unloading chips from the test head, and the marking of chips with ink in the event of a test failure, although not mentioned in the above embodiments, will be recognised as being compatible with the above.

Furthermore, in the foregoing embodiments, the method and system aspects of the present invention were described as applied to packaged chips or singulated die IC, the IC being a Bluetooth^{™} compatible design. Those skilled in the art will recognise that the testing method and systems aspects of the present invention can readily be applied to other different radio chips requiring confirmation of conformity with a particular specification for which those chips are designed. Many radio chips require testing for so-called "front end linearity," with the radio specification specifying the linearity and absolute standards required. For example, radio standards such as IEEE802.15.4 ('ZigBee'), 'GSM', and the so called '3G' telephony standards require radio chips which can benefit from specification testing equipment and methods embodying the present invention.

From reading the present disclosure, other modifications will be apparent to persons skilled in the art. Such modifications may involve other features which are already known in the design, manufacture and use of RF testing systems, test heads and component parts thereof and which may be used instead of or in addition to features already described herein without departing from the scope of the present invention as defined by the claims.

## Claims

1. A method for testing a plurality of integrated circuit chips for compliance with a radio standard, each chip having transmission means and receiving means for sending and receiving RF signals, the method comprising:
• placing the chips in close proximity to one another,
• testing (100) the transmission means of each chip with respect to a known good reference chip,
• selecting (104) a number of the chips to form a generating group, the remaining chips forming a receiving group, and
• testing the receiving group (106) using signals generated by the generating group.

2. A method according to claim 1, wherein the chips are mounted on a test board prior to testing.

3. A method according to claim 1 or claim 2, wherein the selection of generating and receiving groups (104, 106) is repeated (108, 110) until all chips have been tested.

4. A method according to claim 3, wherein the number of chips selected to form a generating group is determined at least in part by the testing requirements.

5. A method according to claim 4, wherein the testing requirements specify a test requiring at least two generated signals.

6. A method according to claim 4 or claim 5, wherein the testing requirements specify an intermodulation test requiring three generated signals.

7. A testing system for testing a plurality of integrated circuit chips, each chip having transmission means (10, 20) and receiving means (10, 30) for sending and receiving RF signals, the system comprising
a test board (80) comprising a plurality of chip sockets (82a, b, c) adapted to physically accept and electronically interface with a chip placed therein, and wherein each socket is provided with signal propagation (88) and attenuation means (86) for sending and receiving test signals generated by at least one chip to each of the other sockets.

8. A system according to claim 7, and further comprising a computer (40) having communication, control and data acquisition means (55) for communicating with, controlling and acquiring data from the test board to which it is connected
and where in operation the computer is programmed to select a group of chips (82b) to generate test signals which are propagated via the propagation means to a reception test group of chips (82a).

9. A system according to claim 7 or claim 8, wherein the signals generated by the selected group are radio frequency signals.

10. A computer program comprising instructions for performing a method according to any of claims 1 to 4 when run on a testing computer (40).

11. A computer readable storage medium (60) having recorded thereon data representing instructions for performing a method according to any of claims 1 to 6 when said data is loaded on a testing computer (40).

## Patentansprüche

1. Verfahren zum Testen einer Vielzahl von Chips integrierter Schaltungen auf Übereinstimmung mit einem Funkstandard, wobei jeder Chip Sendemittel und Empfangsmittel zum Senden und Empfangen von RF-Signalen hat, wobei das Verfahren Folgendes umfasst:
• Platzierung der Chips in kurzer Entfernung zueinander,
• Testen (100) der Sendemittel jeden Chips in Bezug auf einen bekannt guten Referenzchip,
• Auswählen (104) einer Anzahl der Chips, um eine erzeugende Gruppe zu bilden, wobei die restlichen Chips eine empfangende Gruppe bilden, und
• Testen der empfangenden Gruppe (106), wobei die von der erzeugenden Gruppe erzeugten Signale verwendet werden.

2. Verfahren nach Anspruch 1, in dem die Chips vor dem Testen auf eine Testbaugruppe montiert werden.

3. Verfahren nach Anspruch 1 oder 2, in dem die Auswahl der erzeugenden und empfangenden Gruppen (104, 106) solange wiederholt wird (108, 110), bis alle Chips getestet worden sind.

4. Verfahren nach Anspruch 3, in dem die Anzahl der Chips, die ausgewählt werden, um eine erzeugende Gruppe zu bilden, mindestens zum Teil durch die Testanforderungen bestimmt wird.

5. Verfahren nach Anspruch 4, in dem die Testanforderungen einen Test spezifizieren, der mindestens zwei erzeugte Signale erfordert.

6. Verfahren nach Anspruch 4 oder 5, in dem die Testanforderungen einen Intermodulationstest spezifizieren, der mindestens drei erzeugte Signale erfordert.

7. Testsystem zum Testen einer Vielzahl von Chips integrierter Schaltungen, wobei jeder Chip Sendemittel (10, 20) und Empfangsmittel (10, 30) zum Senden und Empfangen von RF-Signalen hat, wobei das Verfahren Folgendes umfasst:
eine Testbaugruppe (80) mit einer Vielzahl von Chipsockeln (82a, b, c), die ausgebildet sind, einen darin platzierten Chip physikalisch anzunehmen und elektronisch anzuschließen, und wobei jeder Sockel mit Signalausbreitungs- (88) und Abschwächungsmitteln (86) zum Senden und Empfangen von Testsignalen, die von mindestens einem Chip erzeugt werden, zu jedem der anderen Sockel versehen ist.

8. System nach Anspruch 7, das weiter einen Computer (40) mit Kommunikations-, Steuerungs- und Datenerfassungsmitteln (55) zum Kommunizieren mit, Steuern und Erfassung von Daten von der Testbaugruppe, an die er angeschlossen ist, umfasst,
und wo der Computer im Betrieb programmiert ist, eine Gruppe von Chips (82b) auszuwählen, um Testsignale zu erzeugen, die über die Ausbreitungsmittel zu einer Empfangstestgruppe von Chips (82a) verbreitet werden.

9. System nach Anspruch 7 oder 8, in dem die durch die ausgewählte Gruppe erzeugten Signale Radiofrequenzsignale sind.

10. Computerprogramm, das Befehle zum Durchführen eines Verfahrens nach einem der Ansprüche 1 bis 4 umfasst, wenn es auf einem Testcomputer (40) läuft.

11. Computerlesbares Speichermedium (60) mit darauf aufgezeichneten Daten, die Befehle zum Durchführen eines Verfahrens nach einem der Ansprüche 1 bis 6 repräsentieren, wenn die genannten Daten auf einen Testcomputer (40) geladen werden.

## Revendications

1. Procédé pour réaliser le test d'une pluralité de puces de circuit intégré pour conformité à un standard radio, chaque puce ayant des moyens d'émission et des moyens de réception pour envoyer et recevoir des signaux RF, le procédé comprenant:
• le placement des puces très proches les unes des autres,
• le test (100) des moyens d'émission de chaque puce selon une bonne puce de référence connue,
• la sélection (104) d'un certain nombre de puces pour former un groupe générateur, les puces restantes formant un groupe récepteur, et
• le test du groupe récepteur (106) en utilisant les signaux générés par le groupe générateur.

2. Procédé selon la revendication 1, dans lequel les puces sont montées sur une carte de test avant le test.

3. Procédé selon la revendication 1 ou la revendication 2, dans lequel la sélection des groupes générateur et récepteur (104, 106) est répétée (108, 110) jusqu'à ce que toutes les puces aient été testées.

4. Procédé selon la revendication 3, dans lequel le nombre de puces sélectionnées pour former un groupe générateur est déterminé au moins en partie par les spécifications de test.

5. Procédé selon la revendication 4, dans lequel les spécifications de test spécifient un test requérant au moins deux signaux générés.

6. Procédé selon la revendication 4 ou la revendication 5, dans lequel les spécifications de test spécifient un test d'intermodulation requérant trois signaux générés.

7. Système de test pour réaliser le test d'une pluralité de puces de circuit intégré, chaque puce ayant des moyens d'émission (10, 20) et des moyens de réception (10, 30) pour envoyer et recevoir des signaux RF, le système comprenant
une carte de test (80) comprenant une pluralité de supports de puce (82a, b, c) adaptées pour recevoir physiquement et interfacer électroniquement avec une puce placée dans celui-ci, et dans lequel chaque support de connexion est pourvu de moyens de propagation de signal (88) et d'atténuation (86) pour envoyer et recevoir des signaux de test générés par au moins une puce à chacune des autres support de connexion.

8. Système selon la revendication 7, et comprenant en outre un ordinateur (40) ayant des moyens de communication, de commande et d'acquisition de données pour communiquer, commander et acquérir des données de la carte de test à laquelle il est connecté
et où, en fonctionnement, l'ordinateur est programmé pour sélectionner un groupe de puces (82b) pour générer des signaux de test qui sont propagés via les moyens de propagation à un groupe de puces de test de réception (82a).

9. Système selon la revendication 7 ou la revendication 8, dans lequel les signaux générés par le groupe sélectionné sont des signaux de radiofréquence.

10. Programme informatique comprenant des instructions pour exécuter un procédé selon n'importe laquelle des revendications 1 à 4 quand il est exécuté sur un ordinateur de test (40).

11. Support informatique de stockage lisible (60) ayant enregistré sur celui-ci des données représentant les instructions pour exécuter un procédé selon n'importe laquelle des revendications 1 à 6 quand lesdites données sont chargées sur un ordinateur de test (40).
